# EUROPEAN PATENT APPLICATION

(11) **EP 2 461 483 A1**
(43) Date of publication of application: **06.06.2012**
(21) Application number: 10804152.6
(22) Date of filing: 30.03.2010
(51) Int. Cl.: H03K 17/693, H03F 3/68

(54) **TRANSFER GATE CIRCUIT, AND POWER COMBINING CIRCUIT, POWER AMPLIFYING CIRCUIT, TRANSMISSION DEVICE, AND COMMUNICATION DEVICE USING THE TRANSFER GATE CIRCUIT**

(30) Priority: 29.07.2009 JP 2009176249
(71) Applicant: Kyocera Corporation, Kyoto-shi Kyoto 612-8501 (JP)
(72) Inventor: NAGAYAMA,Akira, Tokyo 158-8610 (JP); FUKUOKA,Yasuhiko, Tokyo 158-8610 (JP); IGARASHI,Sadao, Kawasaki-shi Kanagawa 213-0012 (JP); ISOYAMA,Shinji, Tokyo 158-8610 (JP)
(74) Representative: Röss, Walter Josef Alfred
(86) International application number: PCT/JP2010/055625
(87) International publication number: WO 2011/013403

(57) **Abstract**

Provided are a transfer gate circuit that has reduced disturbance in an output waveform thereof, a power combining circuit using the transfer gate circuit, and a transmission device and a communication device that use the power combining circuit. The transfer gate circuit includes: output terminals (3, 4) ; a transistor (5) including a drain connected to the output terminal (3); a transistor (6) including a drain connected to the output terminal (4); transistors (7, 8) each including a drain connected to the output terminal (3) and each including a source connected to a ground potential; and transistors (9, 10) each including a drain connected to the output terminal (4) and each including a source connected to the ground potential. In the transfer gate circuit, the transistors (5, 6) include sources to which first and second input signals are input, respectively, the transistor (5) includes a gate to which a signal in phase with the second input signal is input, the transistor (6) includes a gate to which a signal in phase with the first input signal is input, the transistors (7, 9) each include a gate to which a signal in antiphase to the second input signal is input, and the transistors (8, 10) each include a gate to which a signal in antiphase to the first input signal is input.

## Description

### Technical Field

The present invention relates to a transfer gate circuit that has particularly reduced disturbance in an output waveform thereof, and to a power combining circuit, a power amplifying circuit, a transmission device, and a communication device that use the transfer gate circuit.

### Background Art

Conventionally, in digital circuits and others, there is known a transfer gate circuit which functions as a switch circuit by turning ON/OFF the conduction between a source terminal and a drain terminal of a transistor depending on a voltage applied to a gate terminal of the transistor (see, for example, Non Patent Document 1).
Non Patent Document 1: Electronic Device [I] First edition, Shokodo, 1979, P172-P173

### Summary of Invention

### Technical Problem

However, in the above-mentioned conventional transfer gate circuit, there has been a problem in that, due to parasitic capacitances between the gate terminal and the source terminal as well as the drain terminal or other factors, there may appear a time region in which the output voltage is not zero though the transistor is in the OFF state because the voltage of the gate terminal is at Low level (reference value or lower), resulting in output waveform disturbance.

Therefore, in the case where the transfer gate circuit described above is used for a power combining circuit or a power amplifier, there is a disadvantage in that power consumption increases to deteriorate combined efficiency or power-added efficiency, and in the case where the transfer gate circuit is applied to a transmission device or a communication device, there is a disadvantage in that power consumption increases.

The present invention has been devised in view of the problems in the conventional technology described above, and it is an object thereof to provide a transfer gate circuit having reduced disturbance in an output waveform thereof, and a power combining circuit, a power amplifying circuit, a transmission device, and a communication device that use the transfer gate circuit.

### Solution to Problem

According to the present invention, there is provided a first transfer gate circuit, including: a first output terminal and a second output terminal; a first transistor including a drain terminal connected to the first output terminal; a second transistor including a drain terminal connected to the second output terminal; and a third transistor and a fourth transistor each including a drain terminal connected to the first output terminal and each including a source terminal connected to a ground potential, in which: the first transistor includes a source terminal to which a first input signal is input, and the second transistor includes a source terminal to which a second input signal is input; the first transistor includes a gate terminal to which a signal in phase with the second input signal is input, and the second transistor includes a gate terminal to which a signal in phase with the first input signal is input; and the third transistor includes a gate terminal to which a signal in antiphase to the second input signal is input, and the fourth transistor includes a gate terminal to which a signal in antiphase to the first input signal is input.

According to the present invention, there is also provided a second transfer gate circuit, which is obtained based on the first transfer gate circuit according to the present invention and further includes a fifth transistor and a sixth transistor each including a drain terminal connected to the second output terminal and each including a source terminal connected to the ground potential, and in which the sixth transistor includes a gate terminal to which the signal in antiphase to the second input signal is input, and the fifth transistor includes a gate terminal to which the signal in antiphase to the first input signal is input.

According to the present invention, there is further provided a third transfer gate circuit, which is obtained based on the first transfer gate circuit according to the present invention and further includes: a seventh transistor including a drain terminal connected to a gate terminal thereof and also connected to a power supply potential via a first resistor, and including a source terminal connected to the ground potential via a second resistor; and an eighth transistor including a drain terminal connected to a gate terminal thereof and also connected to the power supply potential via a third resistor, and including a source terminal connected to the ground potential via a fourth resistor, and in which: the gate terminal of the seventh transistor and the gate terminal of the first transistor are connected to each other, and the source terminal of the second transistor and the gate terminal of the first transistor are connected to each other via a first capacitor; and the gate terminal of the eighth transistor and the gate terminal of the second transistor are connected to each other, and the source terminal of the first transistor and the gate terminal of the second transistor are connected to each other via a second capacitor.

According to the present invention, there is provided a first power combining circuit, including: the transfer gate circuit according to the present invention; a ninth transistor including a gate terminal connected to the first output terminal of the transfer gate circuit and a source terminal connected to the ground potential; a first low-pass filter circuit including one terminal connected to a drain terminal of the ninth transistor and another terminal connected to a power supply potential; and an output matching circuit including one terminal connected to the drain terminal of the ninth transistor and another terminal connected to a third output terminal.

According to the present invention, there is also provided a second power combining circuit, including: the second transfer gate circuit according to the present invention; a ninth transistor including a gate terminal connected to the first output terminal of the transfer gate circuit and a source terminal connected to the ground potential; a tenth transistor including a gate terminal connected to the second output terminal of the transfer gate circuit and a source terminal connected to the ground potential; a first low-pass filter circuit including one terminal connected to a drain terminal of the ninth transistor and another terminal connected to a power supply potential; and a second low-pass filter circuit including one terminal connected to a drain terminal of the tenth transistor and another terminal connected to the power supply potential; and an output matching circuit including one terminal connected to the drain terminal of the ninth transistor and the drain terminal of the tenth transistor, and another terminal connected to a third output terminal.

According to the present invention, there is provided a power amplifying circuit, including: the power combining circuit having the configuration described above; and a constant envelope signal generation circuit for converting an input signal having envelope fluctuations into a first constant envelope signal and a second constant envelope signal and outputting the first constant envelope signal and the second constant envelope signal as the first input signal and the second input signal, respectively.

According to the present invention, there is provided a transmission device, including: a transmission circuit; an antenna; and the power amplifying circuit having the configuration described above, in which the antenna is connected to the transmission circuit via the power amplifying circuit.

According to the present invention, there is provided a communication device, including: a transmission circuit; a reception circuit; an antenna; and the power amplifying circuit having the configuration described above, in which the antenna is connected to the transmission circuit and the reception circuit, and the power amplifying circuit is interposed between the transmission circuit and the antenna.

Note that, "the signal in antiphase (antiphase signal)" as used herein means a signal in which the voltage state of High level (reference value or higher) and the voltage state of Low level (reference value or lower) are reversed to an original signal, and, in the case of a sine wave or the like, the center of the amplitude is the reference value. Accordingly, a square-wave signal in which the state of High level and the state of Low level are reversed to an original sine-wave signal is also included in "the signal in antiphase (antiphase signal)".

### Advantageous Effects of Invention

According to the first transfer gate circuit of the present invention, when the voltage of the second input signal is at High level (voltage state higher than the reference value), the first transistor enters the ON state so that the drain terminal and the source terminal are conducted to each other, and when the voltage of the first input signal is at High level, the second transistor enters the ON state so that the drain terminal and the source terminal are conducted to each other. Therefore, the first transfer gate circuit according to the present invention can function so that the first input signal is output from the first output terminal when the voltage of the second input signal is at High level and the second input signal is output from the second output terminal when the voltage of the first input signal is at High level.

Further, according to the first transfer gate circuit of the present invention, when at least one of the first input signal and the second input signal is at Low level (voltage lower than the reference value), at least one of the third and fourth transistors enters the ON state, and hence the first output terminal can be connected to the ground potential. Accordingly, in the signal output from the first output terminal, the voltage when at least one of the first input signal and the second input signal is at Low level can be reduced to almost zero.

According to the second transfer gate circuit of the present invention, when at least one of the first input signal and the second input signal is at Low level (voltage lower than the reference value), at least one of the fifth and sixth transistors enters the ON state, and hence the second output terminal can be connected to the ground potential. Accordingly, in the signal output from the second output terminal, the voltage when at least one of the first input signal and the second input signal is at Low level can be reduced to almost zero. According to the third transfer gate circuit of the present invention, through the setting of the values of the first and second resistors and the power supply potential, the potential at the gate terminal of the seventh transistor can be fixed to a desired value to some extent, and hence a slow fluctuation in the potential at the gate terminal of the first transistor can be prevented so that the potential can be converged to a desired value.

Further, according to the third transfer gate circuit of the present invention, through the setting of the values of the third and fourth resistors and the power supply potential, the potential at the gate terminal of the eighth transistor can be fixed to a desired value to some extent, and hence a slow fluctuation in the potential at the gate terminal of the second transistor can be prevented so that the potential can be converged to a desired value.

According to the first power combining circuit of the present invention, an output signal having the amplitude that varies in contrast to the variation of the phase difference between the first input signal and the second input signal can be output from the third output terminal, and, as compared with the case where the first input signal and the second input signal are directly input to the gate terminal of the ninth transistor without passing through the transfer gate circuit, the period in which the ninth transistor is in the ON state can be reduced, and hence a power combining circuit having high combined efficiency can be obtained.

According to the second power combining circuit of the present invention, an output signal having the amplitude that varies in contrast to the variation of the phase difference between the first input signal and the second input signal can be output from the third output terminal, and, as compared with the case where the first input signal and the second input signal are directly input to the gate terminals of the ninth and tenth transistors, respectively, without passing through the transfer gate circuit, the periods in which the ninth and tenth transistors are in the ON state can be reduced, and hence a power combining circuit having high combined efficiency can be obtained.

According to the power amplifying circuit of the present invention, a saturated amplifying circuit having high power-added efficiency can be used as first and second amplifying circuits so to amplify the first and second constant envelope signals and then the amplified constant envelope signals can be combined and output. It is therefore possible to obtain a power amplifying circuit capable of amplifying the input signal having envelope fluctuations at high power-added efficiency and outputting the amplified signal.

According to the transmission device of the present invention, the power amplifying circuit of the present invention operable even in the high frequency region and having high power-added efficiency can be used to amplify a transmission signal having envelope fluctuations sent from the transmission circuit. It is therefore possible to obtain a transmission device operable even in the high frequency region and having low power consumption.

According to the communication device of the present invention, the power amplifying circuit of the present invention operable even in the high frequency region and having high power-added efficiency can be used to amplify a transmission signal having envelope fluctuations sent from the transmission circuit. It is therefore possible to obtain a communication device operable even in the high frequency region and having low power consumption.

### Brief Description of Drawings

[FIG. 1] FIG. 1 is a circuit diagram illustrating a transfer gate circuit according to a first example of an embodiment of the present invention.
[FIG. 2] FIG. 2 is a circuit diagram illustrating an example of a phase inverter circuit of FIG. 1.
[FIG. 3] FIG. 3 is a circuit diagram illustrating a transfer gate circuit according to a second example of the embodiment of the present invention.
[FIG. 4] FIG. 4 is a circuit diagram illustrating a transfer gate circuit according to a third example of the embodiment of the present invention.
[FIG. 5] FIG. 5 is a circuit diagram illustrating a transfer gate circuit according to a fourth example of the embodiment of the present invention.
[FIG. 6] FIG. 6 is a circuit diagram illustrating a transfer gate circuit according to a fifth example of the embodiment of the present invention.
[FIG. 7] FIG. 7 is a circuit diagram illustrating an example of a square-wave converter circuit of FIG. 6.
[FIG. 8] FIG. 8 is a circuit diagram illustrating a power combining circuit according to a sixth example of the embodiment of the present invention.
[FIG. 9] FIG. 9 is a circuit diagram illustrating a power combining circuit according to a seventh example of the embodiment of the present invention.
[FIG. 10] FIG. 10 is a block diagram illustrating a power amplifying circuit according to an eighth example of the embodiment of the present invention.
[FIG. 11] FIG. 11 is a block diagram illustrating a transmission device according to a ninth example of the embodiment of the present invention.
[FIG. 12] FIG. 12 is a block diagram illustrating a communication device according to a tenth example of the embodiment of the present invention.
[FIGS. 13] FIG. 13(a) is a graph showing results of simulation on electrical characteristics of a transfer gate circuit of a comparative example, and FIG. 13(b) is a graph showing results of simulation on electrical characteristics of the transfer gate circuit according to the fifth example of the embodiment of the present invention.

### Description of Embodiments

Hereinafter, a high frequency circuit of the present invention is described in detail with reference to the accompanying drawings.

### [First Example of Embodiment]

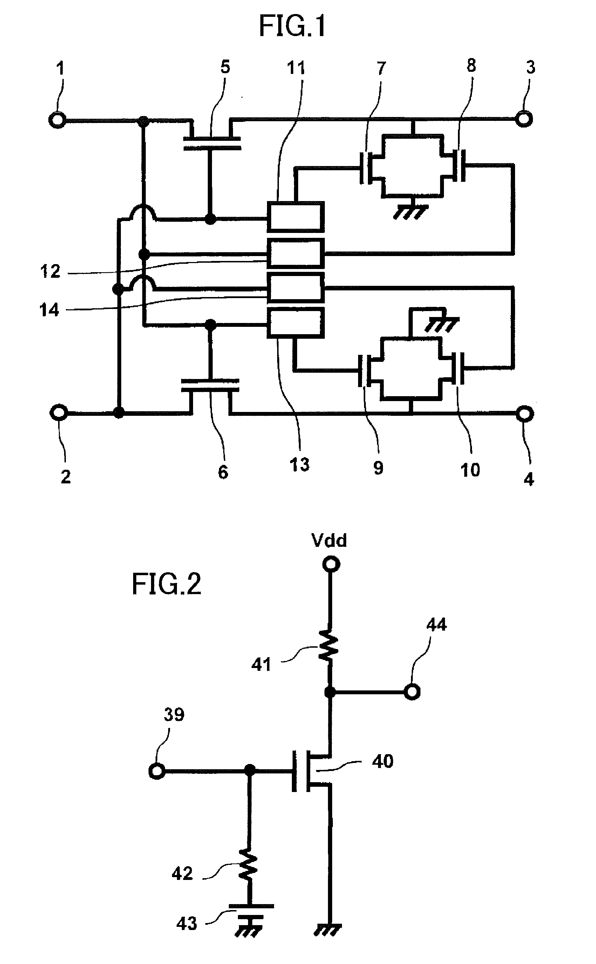

FIG. 1 is a circuit diagram illustrating a transfer gate circuit according to a first example of an embodiment of the present invention. FIG. 2 is a circuit diagram illustrating an example of phase inverter circuits 11, 12, 13, and 14 of FIG. 1.

The transfer gate circuit of this example includes, as illustrated in FIG. 1, a first input terminal 1, a second input terminal 2, a first output terminal 3, a second output terminal 4, a first transistor 5, a second transistor 6, a third transistor 7, a fourth transistor 8, a fifth transistor 9, a sixth transistor 10, a first phase inverter circuit 11, a second phase inverter circuit 12, a third phase inverter circuit 13, and a fourth phase inverter circuit 14. Note that, the first to sixth transistors 5 to 10 are all n-channel FETs.

In the transfer gate circuit of this example, the first transistor 5 has a source terminal connected to the first input terminal 1 and a drain terminal connected to the first output terminal 3. The second transistor 6 has a source terminal connected to the second input terminal 2 and a drain terminal connected to the second output terminal 4. The third transistor 7 and the fourth transistor 8 each have a drain terminal connected to the first output terminal 3 and a source terminal connected to a ground potential. The fifth transistor 9 and the sixth transistor 10 each have a drain terminal connected to the second output terminal 4 and a source terminal connected to the ground potential.

Further, the first input terminal 1 and a gate terminal of the second transistor 6 are directly connected to each other, the first input terminal 1 and a gate terminal of the fourth transistor 8 are connected to each other via the second phase inverter circuit 12, and the first input terminal 1 and a gate terminal of the fifth transistor 9 are connected to each other via the third phase inverter circuit 13. In addition, the second input terminal 2 and a gate terminal of the first transistor 5 are directly connected to each other, the second input terminal 2 and a gate terminal of the third transistor 7 are connected to each other via the first phase inverter circuit 11, and the second input terminal 2 and a gate terminal of the sixth transistor 10 are connected to each other via the fourth phase inverter circuit 14.

In the transfer gate circuit of this example, the first to fourth phase inverter circuits 11 to 14 are each a circuit having a function of inverting the voltage state of High level (reference value or higher) and the voltage state of Low level (reference value or lower) with respect to an input signal and outputting the resultant signal, and, in the case of a sine wave or the like, the center of the amplitude is the reference value. That is, the first to fourth phase inverter circuits 11 to 14 are each a circuit that outputs a signal of Low level when a signal of High level is input and outputs a signal of High level when a signal of Low level is input, as exemplified by a NOT circuit of logic circuits. Note that, a positive voltage (such as +2 V) can be used as High level, and 0 V or the like can be used as Low level.

According to the transfer gate circuit of this example having the configuration described above, the gate terminal of the first transistor 5 is connected to the second input terminal 2, and the gate terminal of the second transistor 6 is connected to the first input terminal 1. Therefore, in the case where a first input signal is input to the first input terminal 1 and a second input signal is input to the second input terminal 2, when the voltage of the first input signal is at High level, the second transistor 6 enters the ON state to allow the second input signal to pass through the second transistor 6 toward the second output terminal 4, and when the voltage of the second input signal is at High level, the first transistor 5 enters the ON state to allow the first input signal to pass through the first transistor 5 toward the first output terminal 3. Thus, the transfer gate circuit functions so that the first input signal is output from the first output terminal 3 when the voltage of the second input signal is at High level and that the second input signal is output from the second output terminal 4 when the voltage of the first input signal is at High level. Note that, if the voltages of High level of the first input signal and the second input signal fall below threshold voltages of the first and second transistors 5 and 6, respectively, a bias voltage is added to adjust the voltages.

Further, in the transfer gate circuit of this example, the second input terminal 2 and the gate terminal of the third transistor 7 are connected to each other via the first phase inverter circuit 11, and the first input terminal 1 and the gate terminal of the fourth transistor 8 are connected to each other via the second phase inverter circuit 12. According to the transfer gate circuit of this example having the configuration described above, when at least one of the first input signal and the second input signal is at Low level, the signal of High level is output from at least one of the first phase inverter circuit 11 and the second phase inverter circuit 12. Accordingly, at least one of the third transistor 7 and the fourth transistor 8 enters the ON state to connect the first output terminal 3 and the drain terminal of the first transistor 5 to the ground potential. Therefore, the voltage of the output signal from the first output terminal 3 can be reduced to almost zero.

In addition, in the transfer gate circuit of this example, the first input terminal 1 and the gate terminal of the fifth transistor 9 are connected to each other via the third phase inverter circuit 13, and the second input terminal 2 and the gate terminal of the sixth transistor 10 are connected to each other via the fourth phase inverter circuit 14. According to the transfer gate circuit of this example having the configuration described above, when at least one of the first input signal and the second input signal is at Low level, the signal of High level is output from at least one of the third phase inverter circuit 13 and the fourth phase inverter circuit 14. Accordingly, at least one of the fifth transistor 9 and the sixth transistor 10 enters the ON state to connect the second output terminal 4 and the drain terminal of the second transistor 6 to the ground potential. Therefore, the voltage of the output signal from the second output terminal 4 can be reduced to almost zero.

In the conventional transfer gate circuit, there has been a problem in that, due to parasitic capacitances between the gate terminal and the source terminal as well as the drain terminal of a transistor serving as a transfer gate or other factors, there may appear a time region in which the output voltage is not zero though the transistor is in the OFF state because the voltage of the gate terminal is at Low level, resulting in output waveform disturbance. For example, in the case where the potential applied to the source terminal is high, even if the transistor is in the OFF state, a part of the signal applied to the source terminal may be transmitted to the drain terminal. In the case where the output signal is a square wave, in the output waveform thereof, in a time region in which the voltage should be zero before the rising and after the falling of the waveform, a hill portion called plateau in which the voltage gently changes between zero (Low level) and High level is generated. The occurrence of the plateau described above reduces the dynamic range of the output signal. Further, particularly in the case of dealing with a signal having a short pulse width, the occurrence of the plateau causes waveform distortion to deteriorate the signal quality.

According to the transfer gate circuit of this example, when at least one of the first input signal and the second input signal is at Low level, the first output terminal 3 and the drain terminal of the first transistor 5, as well as the second output terminal 4 and the drain terminal of the second transistor 6, are connected to the ground potential, and hence the voltages of the output signals from the first output terminal 3 and the second output terminal 4 can be reduced to almost zero. This prevents waveform disturbance in the output signal caused by the occurrence of the plateau, with the result that the output signals can be output from the first and second output terminals 3 and 4 only when both the first input signal and the second input signal are at High level.

Note that, this example is described for single-ended signal input, but, in the case of balanced signal input, where the phase of one signal is inverted by 180° to that of the other signal, it is possible to obtain a transfer gate circuit capable of preventing waveform disturbance in the output signal caused by the occurrence of the plateau, without using the phase inverter circuits 11, 12, 13, and 14.

FIG. 2 illustrates an example of the phase inverter circuits 11, 12, 13, and 14. The phase inverter circuit of FIG. 2 includes an input terminal 39, a transistor 40, a fifth resistor 41, a sixth resistor 42, a DC voltage source 43, and an output terminal 44. The transistor 40 has a gate terminal connected to the input terminal 39 and also connected to the ground potential via the sixth resistor 42 and the DC voltage source 43. Further, the transistor 40 has a drain terminal connected to the output terminal 44 and also connected to a power supply potential Vdd via the resistor 41. The transistor 40 has a source terminal connected to the ground potential.

The transistor 40 changes between the ON state and the OFF state, depending on the voltage of the input signal input to the input terminal 39 connected to the gate terminal thereof. Further, a DC bias voltage, which is determined by the sixth resistor 42 and the DC voltage source 43, is applied to the gate terminal of the transistor 40, to thereby determine a voltage of the input signal at which the transistor 40 enters the ON state. Note that, it is assumed that the input terminal 39 is applied with a voltage signal sufficient for operating the transistor 40 in the saturation region.

When the signal of High level is input to the input terminal 39 and the transistor 40 is in the ON state, the drain terminal of the transistor 40 is connected to the ground, and the ground potential, namely the signal of Low level, is output to the output terminal 44. On the other hand, when the signal of Low level is input to the input terminal 39 and the transistor 40 is in the OFF state, the power supply voltage Vdd appears directly at the drain terminal of the transistor 40, and hence the signal of High level is output to the output terminal 44. In this way, an antiphase signal in which High level and Low level are reversed to those of the signal input to the input terminal 39, namely a phase-inverted signal, can be output from the output terminal 44.

### [Second Example of Embodiment]

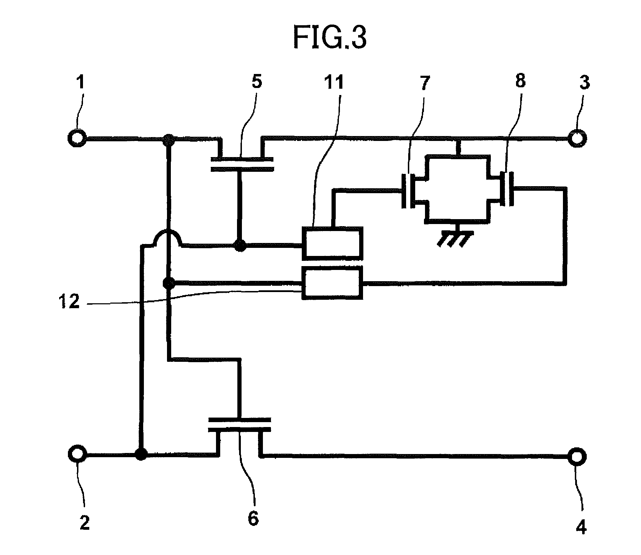

FIG. 3 is a circuit diagram illustrating a transfer gate circuit according to a second example of the embodiment of the present invention. Note that, in this example, only the difference from the above-mentioned first example is described, and similar components are denoted by the same reference symbols to omit repetitive description thereof.

The transfer gate circuit of this example has a configuration as illustrated in FIG. 3 in which the fifth transistor 9, the sixth transistor 10, the third phase inverter circuit 13, and the fourth phase inverter circuit 14 included in the transfer gate circuit of FIG. 1 are omitted.

According to the transfer gate circuit of this example having the configuration described above, similarly to the transfer gate circuit of the first example, the output signal can be output from the first output terminal 3 only when both the first input signal and the second input signal are at High level.

Note that, in the transfer gate circuit of this example, the output signal of the second output terminal 4 can be used as a reference signal. Further, in the transfer gate circuit of this example, the second output terminal 4 may be terminated.

### [Third Example of Embodiment]

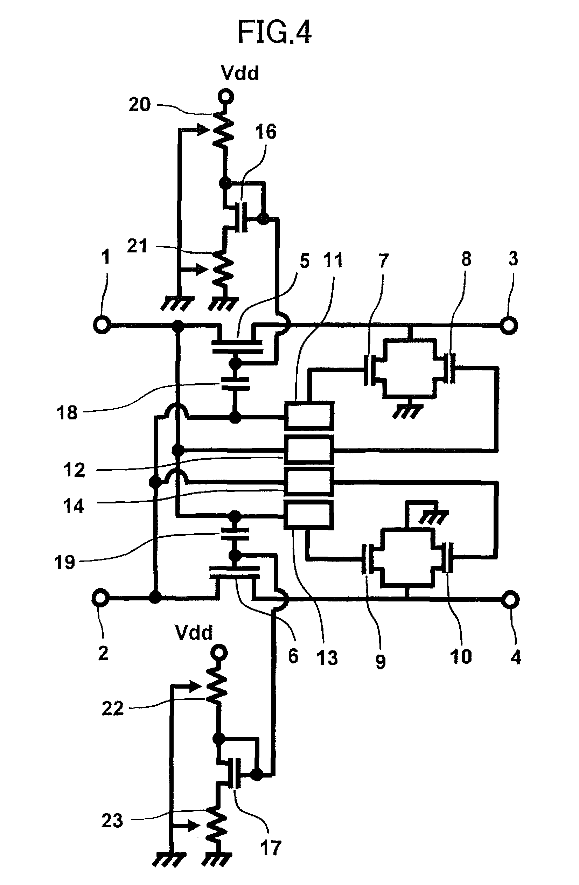

FIG. 4 is a circuit diagram illustrating a transfer gate circuit according to a third example of the embodiment of the present invention. Note that, in this example, only the difference from the above-mentioned first example is described, and similar components are denoted by the same reference symbols to omit repetitive description thereof.

The transfer gate circuit of this example further includes, as illustrated in FIG. 4, a seventh transistor 16, an eighth transistor 17, a first capacitor 18, a second capacitor 19, a first resistor 20, a second resistor 21, a third resistor 22, and a fourth resistor 23.

The seventh transistor 16 has a drain terminal connected to a gate terminal of the seventh transistor 16 and also connected to the power supply potential Vdd via the first resistor 20 . Further, the seventh transistor 16 has a source terminal connected to the ground potential via the second resistor 21. Then, the gate terminal of the seventh transistor 16 is directly connected to the gate terminal of the first transistor 5. Those seventh transistor 16, first resistor 20, and second resistor 21 form a first voltage stabilizing circuit.

The eighth transistor 17 has a drain terminal connected to a gate terminal of the eighth transistor 17 and also connected to the power supply potential Vdd via the third resistor 22. Further, the seventh transistor 16 has a source terminal connected to the ground potential via the fourth resistor 23. Then, the gate terminal of the eighth transistor 17 is directly connected to the gate terminal of the second transistor 6. Those eighth transistor 17, third resistor 22, and fourth resistor 23 form a second voltage stabilizing circuit.

Further, in the transfer gate circuit of this example, the source terminal of the second transistor 6 and the second input terminal 2 are connected to the gate terminal of the first transistor 5 via the first capacitor 18, and the source terminal of the first transistor 5 and the first input terminal 1 are connected to the gate terminal of the second transistor 6 via the second capacitor 19.

According to the transfer gate circuit of this example having the configuration described above, the gate terminal and the drain terminal of the seventh transistor 16 are connected to each other, and hence the seventh transistor 16 can be operated as a constant current source. Then, the value of a current flowing through the seventh transistor 16 can be determined by the first resistor 20 and the second resistor 21. Thus, through the setting of the values of the first and second resistors 20 and 21 and the power supply potential Vdd, a gate voltage of the seventh transistor 16 functioning as the constant current source can be maintained to a desired value. The gate terminal of this seventh transistor 16 is directly connected to the gate terminal of the first transistor 5, and hence a gate voltage of the first transistor 5 can be stabilized to a desired value. That is, in the case where a pulse wave having ringing after the falling edge is applied to the gate terminal of the first transistor 5, normally, every time the ringing exceeds a threshold of the first transistor 5, the first transistor 5 enters the ON state and the signal is adversely transmitted from the source terminal to the drain terminal of the first transistor 5. However, according to the transfer gate circuit of this example, even in the case where a pulse wave having ringing is applied to the gate terminal of the first transistor 5, the first voltage stabilizing circuit operates so as to suppress the fluctuations in the gate voltage of the first transistor 5, and hence the gate voltage of the first transistor 5 can be stabilized. Notethat, the first voltage stabilizing circuit operates at low speed and therefore has no adverse effect on the rising of a pulse wave.

Similarly, the gate terminal and the drain terminal of the eighth transistor 17 are connected to each other, and hence the eighth transistor 17 can be operated as a constant current source. Then, the third resistor 22 and the fourth resistor 23 can determine the value of a current flowing through the eighth transistor 17. Thus, through the setting of the values of the first and second resistors 20 and 21 and the power supply potential Vdd, a gate voltage of the eighth transistor 17 functioning as the constant current source can be maintained to a desired value. The gate terminal of this eighth transistor 17 is directly connected to the gate terminal of the second transistor 6, and hence a gate voltage of the second transistor 6 can be stabilized to a desired value.

In this way, even in the case where a pulse wave having ringing is applied to each of the gate terminals of the first transistor 5 and the second transistor 6, the first voltage stabilizing circuit and the second voltage stabilizing circuit reduce the effect of the ringing, and therefore the waveform disturbance of the output signals from the first and second output terminals 3 and 4 can be reduced.

Note that, in the transfer gate circuit of this example, the first resistor 20, the second resistor 21, the third resistor 22, and the fourth resistor 23 are variable resistors, but may be fixed resistors. Further, those resistors may each be a level shifter formed of a diode, instead of the resistor.

### [Fourth Example of Embodiment]

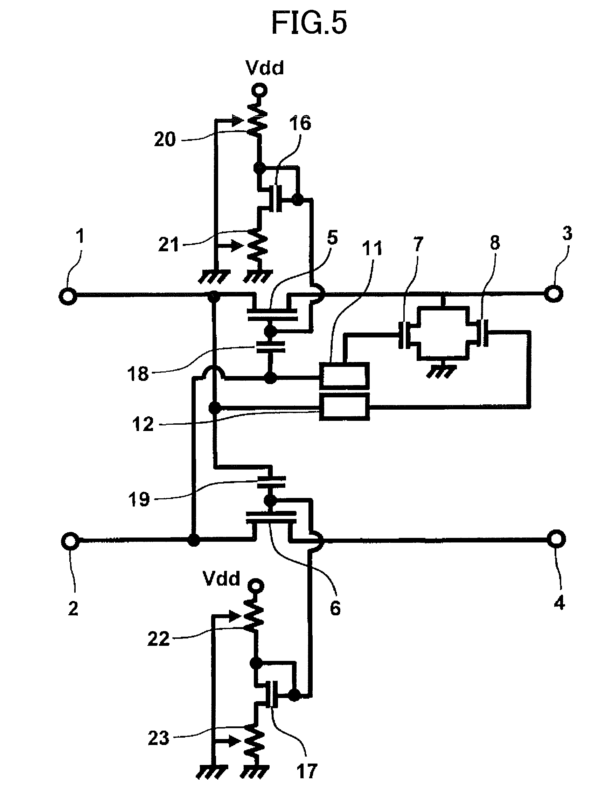

FIG. 5 is a circuit diagram illustrating a transfer gate circuit according to a fourth example of the embodiment of the present invention. Note that, in this example, only the difference from the above-mentioned third example is described, and similar components are denoted by the same reference symbols to omit repetitive description thereof.

The transfer gate circuit of this example has a configuration as illustrated in FIG. 5 in which the fifth transistor 9, the sixth transistor 10, the third phase inverter circuit 13, and the fourth phase inverter circuit 14 included in the transfer gate circuit of FIG. 4 are omitted.

According to the transfer gate circuit of this example having the configuration described above, similarly to the transfer gate circuit of the third example, the gate voltages of the first and second transistors 5 and 6 can be stabilized to desired values.

Note that, in the transfer gate circuit of this example, the output signal of the second output terminal 4 can be used as a reference signal. Further, in the transfer gate circuit of this example, the second output terminal 4 may be terminated.

### [Fifth Example of Embodiment]

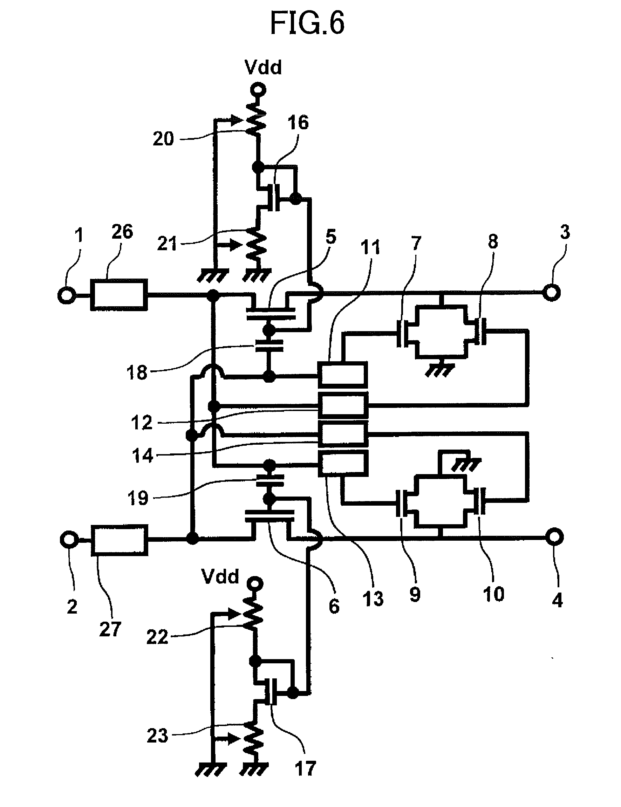

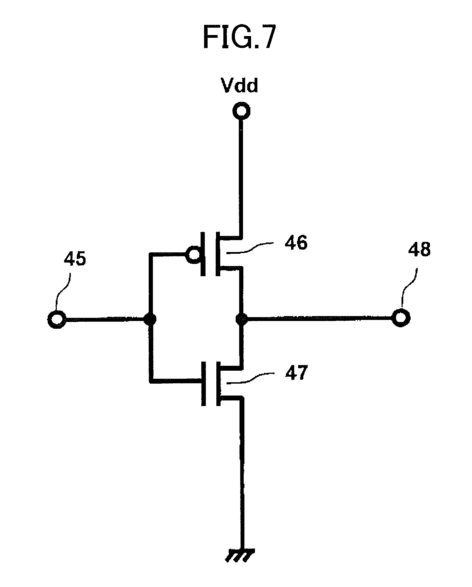

FIG. 6 is a circuit diagram illustrating a transfer gate circuit according to a fifth example of the embodiment of the present invention. FIG. 7 is a circuit diagram illustrating an example of a first square-wave converter circuit 26 and a second square-wave converter circuit 27 of the transfer gate circuit of FIG. 6. Note that, in this example, only the difference from the above-mentioned third example is described, and similar components are denoted by the same reference symbols to omit repetitive description thereof.

The transfer gate circuit of this example further includes, as illustrated in FIG. 6, the first square-wave converter circuit 26 and the second square-wave converter circuit 27. The first square-wave converter circuit 26 is interposed between the first input terminal 1, and the source terminal of the first transistor 5, the second phase inverter circuit 12, the third phase inverter circuit 13, and the second capacitor 19. The second square-wave converter circuit 27 is interposed between the second input terminal 2, and the source terminal of the second transistor 6, the first phase inverter circuit 11, the fourth phase inverter circuit 14, and the first capacitor 18.

According to the transfer gate circuit of this example having the configuration described above, even in the case where the first input signal and the second input signal are sine-wave signals or the like, the first square-wave converter circuit 26 and the second square-wave converter circuit 27 can change the sine-wave signals into square-wave signals and output the square-wave signals. It is therefore possible to obtain a transfer gate circuit capable of turning ON/OFF the transfer gates more accurately.

FIG. 7 illustrates a circuit diagram as an example of the square-wave converter circuits 26 and 27. The square-wave converter circuit includes an input terminal 45, an eleventh transistor 46, a twelfth transistor 47, and an output terminal 48. The eleventh transistor 46 has a gate terminal connected to the input terminal 45 and a source terminal connected to the power supply potential Vdd. The twelfth transistor 47 has a gate terminal connected to the input terminal 45 and a source terminal connected to the ground potential. Then, a drain terminal of the eleventh transistor 46 and a drain terminal of the twelfth transistor 47 are connected to the output terminal 48. Note that, the eleventh transistor 46 is a p-channel FET, and the twelfth transistor 47 is an n-channel FET.

According to the square-wave converter circuit having the configuration described above, in the case where a sine-wave voltage is input to the input terminal 45, in a period in which the voltage is positive, the eleventh transistor 46 is turned OFF and the twelfth transistor 47 is turned ON. As a result, a source potential of the twelfth transistor 47 appears substantially directly at the output terminal 48, and 0 V is output. Therefore, the output is inverted to Low level with respect to the input of High level.

Further, in a period in which the voltage is negative, the eleventh transistor 46 is turned ON and the twelfth transistor 47 is turned OFF. As a result, a source potential of the eleventh transistor appears substantially directly at the output terminal 48, and Vdd is output. Therefore, the output is inverted to High level with respect to the input of Low level.

ON/OFF of the eleventh transistor 46 and the twelfth transistor 47 are switched abruptly at around their threshold voltages of approximately 0.5×Vdd. Therefore, in the case where a sine-wave input signal is supplied, when the voltage thereof is a positive voltage, Low level is output, and, when the voltage is a negative voltage, High level is output. Eventually, the sine wave is converted into a square wave.

However, in the case of a small sine-wave input signal, the square-wave converter circuit may have small signal amplification characteristics, and hence High level is not set as the power supply voltage and Low level is not set to the ground potential in some cases. In such case, by connecting the square-wave converter circuits in multiple stages so as to increase the gain of the circuit, it is possible to realize a circuit for conversion from a sine wave to a square wave.

### [Sixth Example of Embodiment]

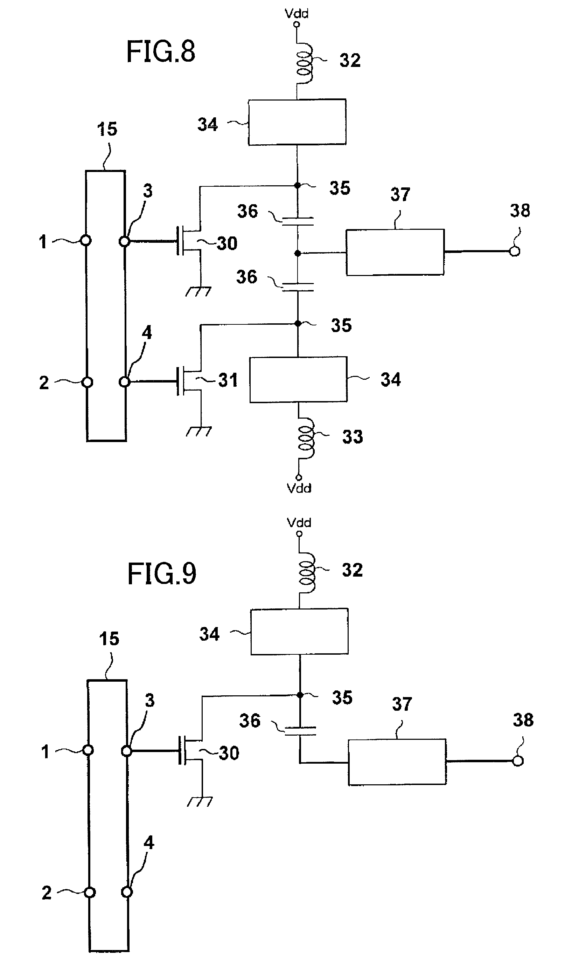

FIG. 8 is a circuit diagram illustrating a power combining circuit according to a sixth example of the embodiment of the present invention. The power combining circuit of this example includes, as illustrated in FIG. 8, a transfer gate circuit 15 of the present invention, a ninth transistor 30, a tenth transistor 31, a first low-pass filter circuit 32, a second low-pass filter circuit 33, harmonic matching circuits 34, capacitors 36, an output matching circuit 37, and a third output terminal 38.

The ninth transistor 30 has a gate terminal connected to the first output terminal 3 of the transfer gate circuit 15 and a source terminal connected to the ground potential. The tenth transistor 31 has a gate terminal connected to the second output terminal 4 of the transfer gate circuit 15 and a source terminal connected to the ground potential. The first low-pass filter circuit 32 has one terminal connected to a drain terminal of the ninth transistor 30 via the harmonic matching circuit 34 and the other terminal connected to the power supply potential Vdd. The second low-pass filter circuit 33 has one terminal connected to a drain terminal of the tenth transistor 31 via the harmonic matching circuit 34 and the other terminal connected to the power supply potential Vdd. The output matching circuit 37 has one terminal connected to the drain terminal of the ninth transistor 30, the drain terminal of the tenth transistor 31, and a pair of the harmonic matching circuits 34 and 34 via the capacitors 36, and has the other terminal connected to the third output terminal 38. Note that, the ninth transistor 30 and the tenth transistor 31 are both n-channel FETs having a pinch-off voltage Vp (threshold voltage at which their drain currents flow).

The output matching circuit 37 sets the impedance seen from the drain terminal of the ninth transistor toward the third output terminal 38 and the impedance seen from the drain terminal of the tenth transistor 31 toward the third output terminal 38 to match at the fundamental frequency. The pair of harmonicmatching circuits 34 set the two impedances so as to provide a short circuit at even harmonics of the fundamental frequency and provide an open circuit at odd harmonics of the fundamental frequency. Therefore, the ninth transistor 30 and the tenth transistor 31 perform class-F operation.

Each of the first low-pass filter circuit 32 and the second low-pass filter circuit 33 has the purpose of blocking the outflow of a high frequency signal and is formed of an inductor. The pair of capacitors 36 are DC blocking capacitors. Note that, a bias Vb (≤Vp) is applied to the gate terminals of the ninth transistor 30 and the tenth transistor 31 by a bias circuit (not shown). In this case, Vp=Vb holds, and hence the ninth transistor 30 and the tenth transistor 31 do not enter the ON state unless a voltage higher than an ON-state voltage Von=Vp-Vb (=0) is additionally applied to the gate terminals thereof.

In the power combining circuit of this example, a first input signal and a second input signal are input, which are constant envelope signals having the same amplitude and the same frequency, such as square waves and half-wave rectified waves, that oscillate at the fundamental cycle, and a fundamental frequency component as a combined signal of the first input signal and the second input signal is output to the third output terminal 38. Combined efficiency (ratio of output power relative to power supplied from the constant voltage power supply Vdd of the ninth transistor 30 and the constant voltage power supply Vdd of the tenth transistor 31) at this point is thus improved.

The transfer gate circuit 15 performs control so that a conduction period of the ninth transistor 30 becomes shorter than a conduction period obtained when the first input signal is directly applied to the gate terminal of the ninth transistor 30, and that the conduction period of the ninth transistor 30 is generated at the fundamental cycle. Further, the transfer gate circuit 15 performs control so that a conduction period of the tenth transistor 31 is shorter than a conduction period obtained when the second input signal is directly applied to the gate terminal of the tenth transistor 31, and that the conduction period of the tenth transistor 31 is generated at the fundamental cycle.

In this way, the ninth transistor 30 and the tenth transistor 31 enter the ON state only during a period in which the first input signal and the second input signal are both higher than Von. Therefore, as compared with the case of directly applying the first input signal to the gate terminal of the ninth transistor 30, the period of the ON state is shortened and the conduction period is also shortened, and hence power supply efficiency (ratio of output power relative to power supplied from the constant voltage power supply Vdd of the ninth transistor 30) is improved. Similarly, as compared with the case of directly applying the second input signal to the gate terminal of the tenth transistor 31, the period of the ON state is shortened, and hence power supply efficiency (ratio of output power relative to power supplied from the constant voltage power supply Vdd of the tenth transistor 31) is improved. As a result, the combined efficiency is improved.

The period in which the first input signal and the second input signal are both higher than Von is generated every fundamental cycle, and hence the conduction periods of the ninth transistor 30 and the tenth transistor 31 are generated every fundamental cycle. Accordingly, the drain voltages of the ninth transistor 30 and the tenth transistor 31 also contain fundamental frequency components. Therefore, by the output matching circuit 37, the fundamental frequency components are extracted from the drain voltages of the ninth transistor 30 and the tenth transistor 31, with the result that a fundamental frequency component of a combined signal of the first input signal and the second input signal is output from the third output terminal 38.

As described above, according to the power combining circuit of this example, the conduction periods of the ninth transistor 30 and the tenth transistor 31 are both generated at the fundamental cycle, and hence the fundamental frequency component of the combined signal of the first input signal and the second input signal is output from the third output terminal 38. This output signal is a signal having the amplitude that varies in contrast to the variation of the phase difference between the first input signal and the second input signal. Further, as compared with the case where the first input signal and the second input signal are directly input to the gate terminals of the ninth and tenth transistors 30 and 31 without passing through the transfer gate circuit 15, the periods in which the ninth and tenth transistors 30 and 31 are in the ON state can be reduced, and hence the power supply efficiency is improved. Therefore, the combined efficiency can be improved.

Note that, in the power combining circuit of this example, an example in which the pair of harmonic matching circuits 34 are provided is described, but, in the case where the ninth transistor 30 and the tenth transistor 31 are not caused to perform class-F operation, the harmonic matching circuits 34 are unnecessary.

### [Seventh Example of Embodiment]

FIG. 9 is a circuit diagram illustrating a power combining circuit according to a seventh example of the embodiment of the present invention. The power combining circuit of this example has a configuration as illustrated in FIG. 9 in which the tenth transistor 31, the second low-pass filter circuit 33, and one of the harmonic matching circuits 34 connected thereto, and one of the capacitors 36 connected thereto included in the power combining circuit of FIG. 7 are omitted. Note that, in this example, only the difference from the above-mentioned sixth example is described, and similar components are denoted by the same reference symbols to omit repetitive description thereof.

According to the power combining circuit of this example having the configuration described above, similarly to the power combining circuit of the sixth example, a signal having the amplitude that varies in contrast to the variation of the phase difference between the first input signal and the second input signal can be output from the third output terminal 38, and the combined efficiency can be improved.

### [Eighth Example of Embodiment]

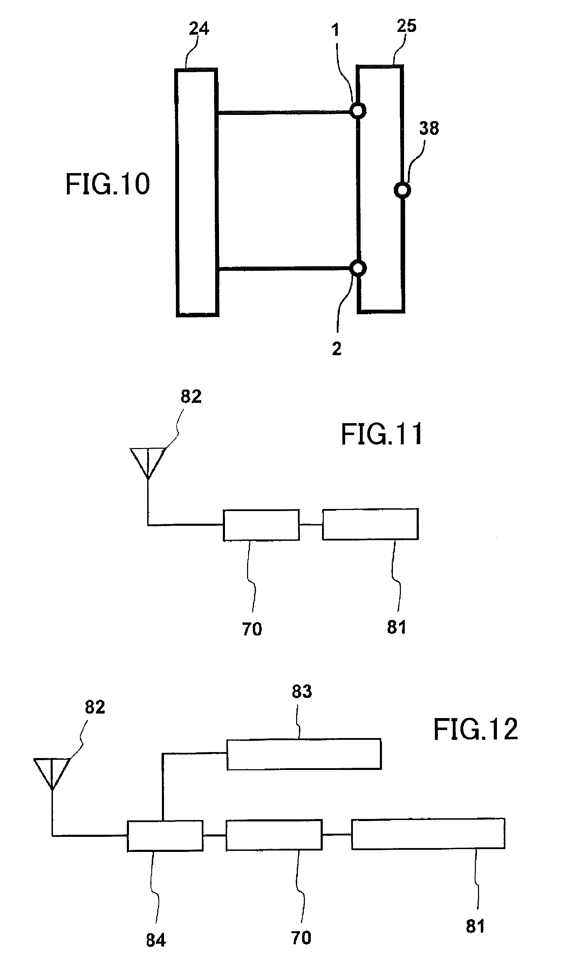

FIG. 10 is a circuit diagram illustrating a power amplifying circuit according to an eighth example of the embodiment of the present invention. The power combining circuit of this example includes, as illustrated in FIG. 10, a power combining circuit 25 of the present invention and a constant envelope signal generation circuit 24 for converting an input signal having envelope fluctuations into first and second constant envelope signals and outputting the first and second constant envelope signals as first and second input signals to be input to the power combining circuit 25.

According to the power amplifying circuit of this example having the configuration described above, it is possible to obtain a power amplifying circuit capable of amplifying the input signal having envelope fluctuations at high power-added efficiency and outputting the amplified signal.

### [Ninth Example of Embodiment]

FIG. 11 is a block diagram illustrating a configuration example of a transmission device using the power amplifying circuit of the present invention.

In the transmission device of this example, as illustrated in FIG. 11, a transmission circuit 81 is connected to an antenna 82 via a power amplifying circuit 70 of the present invention. According to the transmission device of this example having the configuration described above, a transmission signal having envelope fluctuations output from the transmission circuit 81 can be amplified by using the power amplifying circuit 70 of the present invention having low power consumption and high power-added efficiency. It is therefore possible to obtain a transmission device capable of long-term transmission with low power consumption.

### [Tenth Example of Embodiment]

FIG. 12 is a block diagram illustrating a configuration example of a communication device using the power amplifying circuit of the present invention.

In the communication device of this example, as illustrated in FIG. 12, the transmission circuit 81 and a reception circuit 83 are connected to the antenna 82, and the power amplifying circuit 70 of the present invention is interposed between the transmission circuit 81 and the antenna 82. Further, an antenna duplexer circuit 84 is interposed between the antenna 82 and each of the transmission circuit 81 and the reception circuit 83. According to the communication device of this example having the configuration described above, a transmission signal having envelope fluctuations output from the transmission circuit 81 can be amplified by using the power amplifying circuit 70 of the present invention having low power consumption and high power-added efficiency. It is therefore possible to obtain a communication device capable of long-term transmission with low power consumption.

### [Modified Example]

The present invention is not limited to the above-mentioned examples of the embodiment, and various modifications and improvements can be made thereto within the scope not departing from the gist of the present invention.

For example, the above-mentioned first, third, and fifth examples of the embodiment have exemplified the case where the first output terminal 3 and the second output terminal 4 are present independently, but the present invention is not limited thereto. For example, the first output terminal 3 and the second output terminal 4 may be connected to each other as a single output terminal.

### Example

Next, a specific example of the transfer gate circuit of the present invention is described.

Electrical characteristics of the transfer gate circuit according to the fifth example of the embodiment of the present invention illustrated in FIG. 6 were calculated by circuit simulation. As the calculation conditions, the frequency was 2.7 GHz, the power supply voltage was 1.5 V, and the transistors were all n-channel MOSFETs. Analysis was performed for the case where constant envelope signals having a frequency of 2.7 GHz and a phase difference of 179° were input to the first input terminal 1 and the second input terminal 2, respectively.

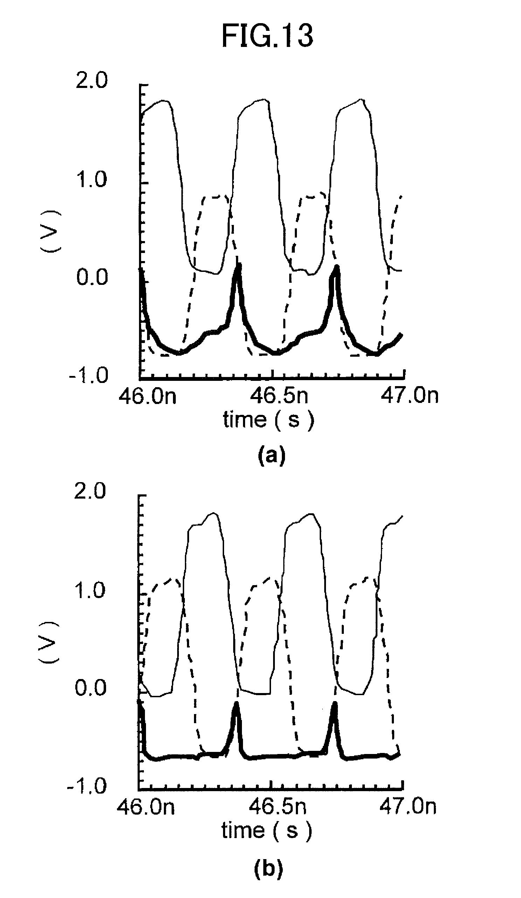

FIG. 13(b) shows results of the simulation. Further, FIG. 13(a) shows results of the simulation on a transfer gate circuit of a comparative example, which is obtained by removing, from the transfer gate circuit illustrated in FIG. 6, the first to fourth transistors 7 to 10, the first to fourth phase inverter circuits 11 to 14, the fifth and sixth transistors 16 and 17, and the first to fourth resistors 20 to 23. In the graphs of FIGS. 13(a) and 13(b), the horizontal axis represents time and the vertical axis represents voltage. Further, the thin solid lines represent a voltage applied to the gate terminal of the first transistor 5, the thin broken lines represent a voltage applied to the source terminal of the first transistor 5, and the thick solid lines represent a voltage of the output signal of the transfer gate circuit appearing at the first output terminal 3.

It can be seen from the graph illustrated in FIG. 13(a) that, in the voltage waveform of the output signal of the transfer gate circuit, in a time region in which the voltage should be zero before the rising and after the falling of the pulsed waveform, a hill portion called plateau in which the voltage gently changes between zero and High level is present. On the other hand, it can be seen from the graph illustrated in FIG. 13(b), no plateau is found before and after a pulsed portion of the voltage waveform of the output signal of the transfer gate circuit, and hence an ideal operation of the transfer gate circuit can be obtained. Therefore, the effectiveness of the present invention could be confirmed.

### Reference Signs List

- 1:: first input terminal
- 2:: second input terminal
- 3:: first output terminal
- 4:: second output terminal
- 5:: first transistor
- 6:: second transistor
- 7:: third transistor
- 8:: fourth transistor
- 9:: fifth transistor
- 10:: sixth transistor
- 11:: first phase inverter circuit
- 12:: second phase inverter circuit
- 13:: third phase inverter circuit
- 14:: fourth phase inverter circuit
- 15:: transfer gate circuit
- 16:: seventh transistor
- 17:: eighth transistor
- 18:: first capacitor
- 19:: second capacitor
- 20:: first resistor
- 21:: second resistor
- 22:: third resistor
- 23:: fourth resistor
- 24:: constant envelope generation circuit
- 25:: power combining circuit
- 30:: ninth transistor
- 31:: tenth transistor
- 32:: first low-pass filter circuit
- 33:: second low-pass filter circuit
- 38:: third output terminal
- 70:: power amplifying circuit
- 81:: transmission circuit
- 82:: antenna
- 83:: reception circuit

## Claims

1. A transfer gate circuit, comprising:
a first output terminal and a second output terminal;
a first transistor including a drain terminal connected to the first output terminal;
a second transistor including a drain terminal connected to the second output terminal; and
a third transistor and a fourth transistor each including a drain terminal connected to the first output terminal and each including a source terminal connected to a ground potential,
wherein the first transistor includes a source terminal to which a first input signal is input, and the second transistor includes a source terminal to which a second input signal is input,
wherein the first transistor includes a gate terminal to which a signal in phase with the second input signal is input, and the second transistor includes a gate terminal to which a signal in phase with the first input signal is input, and
wherein the third transistor includes a gate terminal to which a signal in antiphase to the second input signal is input, and the fourth transistor includes a gate terminal to which a signal in antiphase to the first input signal is input.

2. The transfer gate circuit according to claim 1, further comprising a fifth transistor and a sixth transistor each including a drain terminal connected to the second output terminal and each including a source terminal connected to the ground potential,
wherein the sixth transistor includes a gate terminal to which the signal in antiphase to the second input signal is input, and the fifth transistor includes a gate terminal to which the signal in antiphase to the first input signal is input.

3. The transfer gate circuit according to claim 1, further comprising:
a seventh transistor including a drain terminal connected to a gate terminal thereof and also connected to a power supply potential via a first resistor, and including a source terminal connected to the ground potential via a second resistor; and
an eighth transistor including a drain terminal connected to a gate terminal thereof and also connected to the power supply potential via a third resistor, and including a source terminal connected to the ground potential via a fourth resistor,
wherein the gate terminal of the seventh transistor and the gate terminal of the first transistor are connected to each other, and the source terminal of the second transistor and the gate terminal of the first transistor are connected to each other via a first capacitor, and
wherein the gate terminal of the eighth transistor and the gate terminal of the second transistor are connected to each other, and the source terminal of the first transistor and the gate terminal of the second transistor are connected to each other via a second capacitor.

4. A power combining circuit, comprising:
the transfer gate circuit according to claim 1;
a ninth transistor including a gate terminal connected to the first output terminal of the transfer gate circuit and a source terminal connected to the ground potential;
a first low-pass filter circuit including one terminal connected to a drain terminal of the ninth transistor and another terminal connected to a power supply potential; and
an output matching circuit including one terminal connected to the drain terminal of the ninth transistor and another terminal connected to a third output terminal.

5. A power combining circuit, comprising:
the transfer gate circuit according to claim 2;
a ninth transistor including a gate terminal connected to the first output terminal of the transfer gate circuit and a source terminal connected to the ground potential;
a tenth transistor including a gate terminal connected to the second output terminal of the transfer gate circuit and a source terminal connected to the ground potential;
a first low-pass filter circuit including one terminal connected to a drain terminal of the ninth transistor and another terminal connected to a power supply potential; and
a second low-pass filter circuit including one terminal connected to a drain terminal of the tenth transistor and another terminal connected to the power supply potential; and
an output matching circuit including one terminal connected to the drain terminal of the ninth transistor and the drain terminal of the tenth transistor, and another terminal connected to a third output terminal.

6. A power amplifying circuit, comprising:
the power combining circuit according to claim 4; and
a constant envelope signal generation circuit for converting an input signal having envelope fluctuations into a first constant envelope signal and a second constant envelope signal and outputting the first constant envelope signal and the second constant envelope signal as the first input signal and the second input signal, respectively.

7. A transmission device, comprising:
a transmission circuit;
an antenna; and
the power amplifying circuit according to claim 6,
wherein the antenna is connected to the transmission circuit via the power amplifying circuit.

8. A communication device, comprising:
a transmission circuit;
a reception circuit;
an antenna; and
the power amplifying circuit according to claim 6,
wherein the antenna is connected to the transmission circuit and the reception circuit, and the power amplifying circuit is interposed between the transmission circuit and the antenna.
